# EUROPEAN PATENT APPLICATION

(11) **EP 4 628 919 A1**
(43) Date of publication of application: **08.10.2025**
(21) Application number: 25157273.1
(22) Date of filing: 11.02.2025
(51) Int. Cl.: G01R 33/09

(54) **TMR SENSOR HAVING VORTEX STACK TO ENHANCE LINEARITY**

(30) Priority: 05.04.2024 US 202418628319
(71) Applicant: Allegro MicroSystems, LLC, Manchester, NH 03103-3353 (US)
(72) Inventor: LEHNDORFF, Ronald, 55130 Mainz (DE); BELIN, Noémie, 94800 Villejuif (FR); CAMPIGLIO, Paolo, 94110 Arcueil (FR); RIOULT, Maxime, 91300 Massy (FR)
(74) Representative: South, Nicholas Geoffrey

(57) **Abstract**

Methods and apparatus for devices including TMR elements with a free layer having a vortex layer to provide a magnetic vortex, a spacer layer, a reference layer, and a bias layer to offset the vortex by magnetic exchange bias. Sensor embodiments increase linearity for enhancing sensor performance.

## Description

### BACKGROUND

Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field.

In certain applications, magnetic field sensors include magnetoresistance elements. These elements have an electrical resistance that changes in the presence of an external magnetic field. Spin valves are a type of magnetoresistance element formed from two or more magnetic materials or layers. The simplest form of a spin valve has a reference (or magnetically fixed) layer and a free layer. The resistance of the spin valve changes as a function of the magnetic alignment of the reference and free layers. Typically, the magnetic alignment of the reference layer does not change, while the magnetic alignment of the free layer moves in response to external magnetic fields.

### SUMMARY

Embodiments of the disclosure provide methods and apparatus for a sensor having a TMR stack with a magnetic vortex in the free layer to enhance linearization of the sensing element transfer curves for reducing error. In embodiments, a free layer in the stack is biased by an antiferromagnetic layer to offset the transfer curves along the applied field axis. In example embodiments, TMR elements configured in a Wheatstone bridge or a half bridge, for example, enhance linearity of the bridge elements and reduce error of the bridge output signal.

In one aspect, a device comprises: a TMR element comprising: a free layer having a vortex layer to provide a magnetic vortex; a spacer layer; a reference layer; and a bias layer to offset the vortex by magnetic bias.

A device can further include one or more of the following features: the bias layer comprises an antiferromagnet layer, the bias layer comprises a CoFe layer, the bias layer comprises a magnetic spacer, the bias layer comprises a Ru layer, the vortex layer comprises NiFe, the vortex layer is configured for RKKY coupling with the bias layer, the vortex layer is configured for stray field coupling with the bias layer, the vortex layer is configured for exchange bias, the reference layer comprises an antiferromagnetic layer, the bias layer is configured to shift a transfer curve of the TMR element, the shifted transfer curve is shifted by a given amount of applied field, and/or the bias layer is configured to shift a sensitivity error versus applied field transfer curve of the TMR element.

In a further aspect, a device comprises: two or more biased vortex TMR elements electrically connected to form a half bridge and pinned in opposite directions to create an output signal when a magnetic field is applied; and a free layer biased in opposite directions to have a same pinning direction for enhancing linearity of the output signal of the half bridge.

In another aspect, a device comprises: four or more biased vortex TMR elements electrically connected to form a full bridge and pinned in opposite directions to create an output signal when a magnetic field is applied; and a free layer biased in opposite directions for enhancing linearity of the output signal of the full bridge.

In another aspect, a method comprises: forming a TMR element to comprise: a free layer having a vortex layer to provide a magnetic vortex; a spacer layer; a reference layer; and a bias layer to offset the vortex by magnetic bias.

A method can further include one or more of the following features: the bias layer comprises an antiferromagnet layer, the bias layer comprises a CoFe layer, the bias layer comprises a magnetic spacer, the bias layer comprises a Ru layer, the vortex layer comprises NiFe, the vortex layer is configured for RKKY coupling with the bias layer, the vortex layer is configured for stray field coupling with the bias layer, the vortex layer is configured for exchange bias, the reference layer comprises an antiferromagnetic layer, the bias layer is configured to shift a transfer curve of the TMR element, the shifted transfer curve is shifted by a given amount of applied field, and/or the bias layer is configured to shift a sensitivity error versus applied field transfer curve of the TMR element.

### BRIEF DESCRIPTION OF THE DRAWINGS

The foregoing features of this invention, as well as the invention itself, may be more fully understood from the following description of the drawings in which:
FIG. 1 is a schematic representation of an example sensor having a TMR stack with a magnetic vortex in the free layer to enhance linearization of the sensing element transfer curves for reducing error;
FIG. 2 is schematic representation of a TMR bridge with TMR elements;
FIG. 3 is a schematic representation of a bridge resistor having TMR pillars;
FIG. 4 is a schematic representation of a MTJ with tunneling magnetoresistance;
FIG. 5 is an example TMR stack configuration having a bias layer for offsetting a vortex in a free layer;
FIGs. 6A and 6B are example TMR stack configurations having a bias layer for offsetting a vortex in a free layer;
FIG. 6C shows a conventional vortex configuration for prior art TMR stacks;
FIG. 6D shows a vortex configuration that is offset in accordance with example TMR stack configuration of the present disclosure;
FIG. 7A shows conductance versus applied field and FIG. 7B shows sensitivity error versus applied field for conventional TMR elements with a vortex free layer;
FIG. 8A shows resistance versus applied field for shifted and unshifted transfer curves for TMR elements;
FIG. 8B shows sensitivity error versus applied field for shifted and unshifted transfer curves for TMR elements;
FIG. 9A shows first and second shifted transfer curves for TMR elements having opposite pinning orientations, FIG. 9B shows the output signals of a half bridge constructed from TMR elements with shifted transfer curves and opposite pinning orientations in comparison to the output signal of a half bridge constructed from TMR elements with unshifted transfer curves and opposite pinning orientations, and FIG. 9C shows an example bridge of TMR elements; and
FIG. 10A shows the reduced linearity error of the half bridge output signal from FIG. 9B for shifted transfer curves as compared to centered (unshifted) transfer curves and FIG. 10B shows sensitivity error reduced as compared to centered (unshifted) transfer curves.

### DETAILED DESCRIPTION

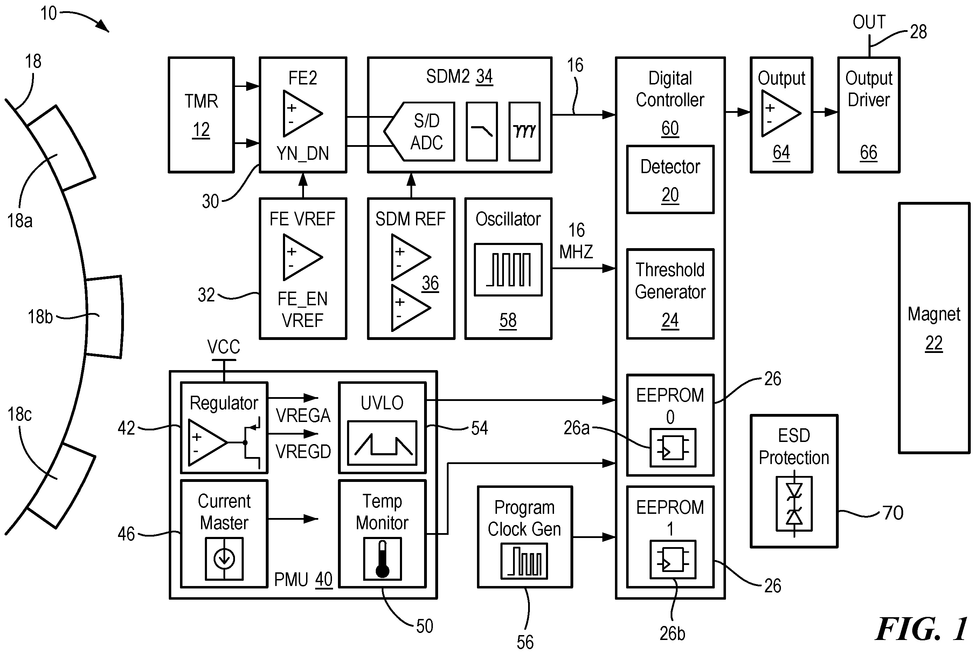

FIG. 1 shows an example magnetic field sensor 10 having at least one magnetic field sensing element 12 that includes one or more TMR elements having a vortex stack for enhancing linearity in accordance with example embodiments of the disclosure. The sensor 10 is configured to generate a magnetic field signal 16 indicative of a magnetic field associated with a target 18 and a detector 20 responsive to the magnetic field signal and to a threshold level from a threshold generator 24 to generate a sensor output signal 28 containing transitions associated with features of the target in response to the magnetic field signal crossing the threshold level.

The target 18 can have a variety of forms, including, but not limited to a gear having gear teeth 18a - 18c or a ring magnet having one or more pole pair. Also, linear arrangements of ferromagnetic objects that move linearly are possible. In the example embedment of FIG. 1, magnetic field sensor 10 may take the form of a rotation detector to detect passing gear teeth, for example, gear teeth 18a-18c of a ferromagnetic gear or, more generally target object 18. A permanent magnet 22 can be placed at a variety of positions proximate to the gear 18, resulting in fluctuations of a magnetic field proximate to the gear as the gear rotates in a so-called "back-bias" arrangement.

Features of the target 18 are spaced from the sensing elements 12 by an airgap. Although intended to be fixed once the sensor 10 is in place in a particular application, the airgap can vary for a variety of reasons. A difference between angles of the transitions of the sensor output signal 28 and locations of the associated features 18a - 18c of the target 28 is referred to as a "hard offset."

Sensing elements 12 can take a variety of forms, such as TMR elements, as may be arranged in one or more bridge or other configurations in order to generate one or more single-ended or differential signals indicative of the sensed magnetic field. A front-end amplifier 30 can be used to process the magnetic field sensing element output signal to generate a further signal for coupling to an analog-to-digital converter (ADC) 34 as may include one or more filters, such as a low pass filter and/or notch filter, and as may take the form of a sigma delta modulator to generate a digital magnetic field signal 16. Features of the magnetic field signal processing can include a front-end reference 32 and a sigma delta reference 36.

Sensor 10 includes a power management unit (PMU) 40 as may contain various circuitry to perform power management functions. For example, a regulator 42 can output a regulated voltage for powering analog circuitry of the sensor (VREGA) and/or a regulated voltage for powering digital circuitry of the sensor (VREGD). A bias current source 46, a temperature monitor 50 and an undervoltage lockout 54 can monitor current, temperature, and voltage levels and provide associated status signals to a digital controller 60. A clock generation element 56 and an oscillator 58 are coupled to the digital controller 60.

Digital controller 60 processes the magnetic field signal 16 to determine the speed, position, and/or direction of movement, such as rotation of target 18 and outputs one or more digital signals to an output protocol module 64. More particularly, controller 60 determines the speed, position, and/or direction of target 18 based on the magnetic field signal 16 and can combine this information with fault information in some embodiments to generate the sensor output signal 28 in various formats. The output of module 64 is fed to an output driver 66 that provides the sensor output signal 28 in various formats, such as a so-called two-wire format in which the output signal is provided in the form of current pulses on the power connection to the sensor or a three-wire format in which the output signal is provided at a separate dedicated output connection. Formats of the output signal 28 can include variety of formats, for example a pulse-width modulated (PWM) signal format, a Single Edge Nibble Transmission (SENT) format, a Serial Peripheral Interface (SPI) format, a Local Interconnect Network (LIN) format, a CAN (Controller Area Network) format, an Inter-Integrated Circuit (I²C) format, or other similar signal formats. Sensor 10 can further include electrostatic discharge (ESD) protection 70.

The digital controller 60 includes detector 20, threshold generator 24, and memory 26 such as EEPROMs 26a, 26b. Memory 26 can be used to store values for various sensor functionality including storing function coefficients for use by the threshold generator 24 in generating the adaptive threshold levels for use by detector 20.

Detector 20 is coupled to receive the threshold level thus generated and the magnetic field signal 16 and compare the received levels to generate a binary, two-state, detector output signal that has transitions when the signal 16 crosses the threshold level. Movement speed of the target 18 can be detected in accordance with the frequency of the binary signal.

It should be appreciated that a direction of rotation of the target 28 may be determined in embodiments containing multiple sensing elements 12 configured to generate phase separated magnetic field signals (as are sometimes referred to as channel signals), in which case the direction of rotation can be determined based on a relative phase or relative time difference (e.g., lag or lead) of a particular edge transition of detector output signals associated with the phase separated magnetic field signals.

It is understood that embodiments of TMR-based sensing elements are useful in a wide variety of magnetic sensors. While an example sensor is shown and described above, any practical magnetic sensor in which TMR sensing elements are desirable can be provided. For example, TMR sensing elements are useful in many magnetic position and angle sensors that require high resolution. Further example sensors in which TMR-based sensing elements are shown and described below.

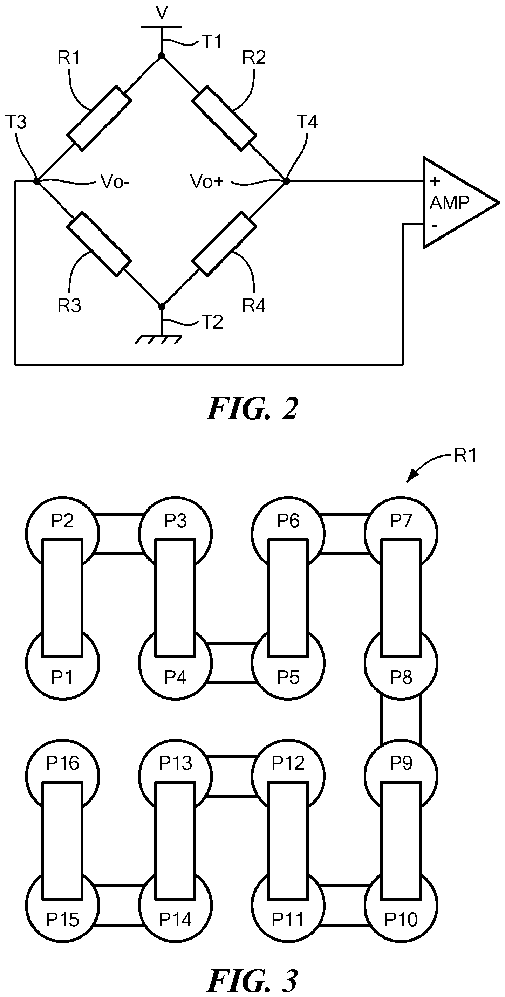

FIG. 2 shows an example TMR bridge 200 having a first resistor R1, a second resistor R2, a third resistor R3, and fourth resistor R4 coupled in a bridge configuration, which can correspond to the sensing elements 12 of FIG. 1. A first terminal T1 is coupled to a voltage supply and a second terminal T2 is coupled to ground (or other potential). A third terminal T3 provides a first differential output signal Vo- and a fourth terminal T4 provides a second differential output signal Vo+. The differential output Vo+, Vo- of the bridge can be provided to an amplifier AMP or other circuitry for processing of the output of the magnetic field sensing elements, such as described above.

FIG. 3 shows an example implementation in which bridge resistor R1 contains sixteen pillars P1-16 that provide the total resistance for R1. It is understood that a TMR resistor that provides a leg of the bridge can comprise any practical number of pillars connected in series and/or in parallel to provide the TMR bridge resistor. Pillars can be designed to have the same or different resistances.

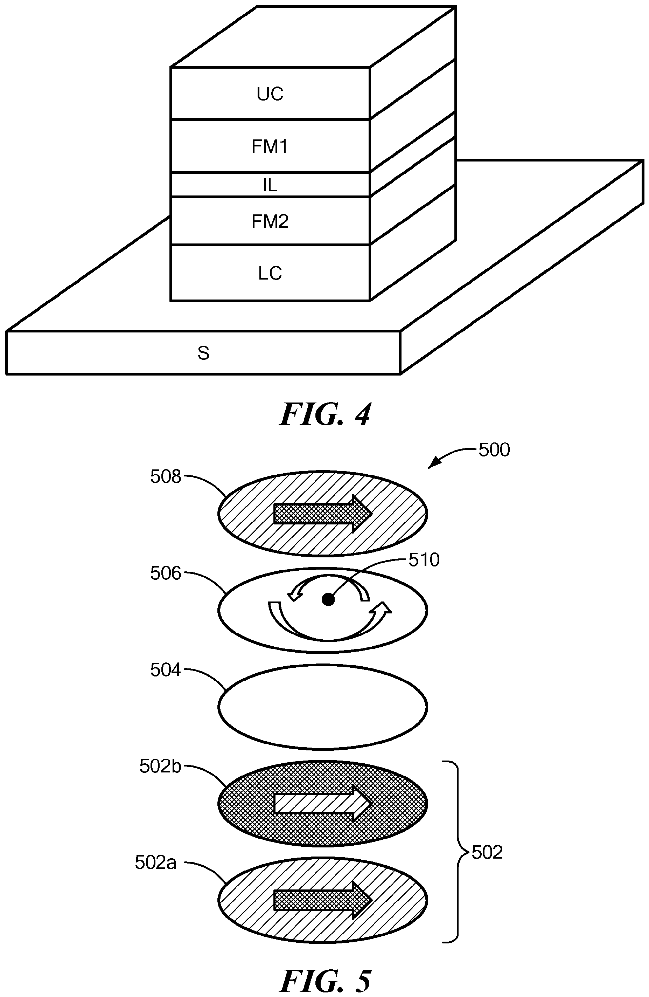

FIG. 4 shows an example magnetic tunnel junction (MTJ) that uses TMR to provide TMR elements, e.g., pillars. As is known in the art, tunneling magnetoresistance (TMR) occurs in a magnetic tunnel junction (MTJ) which has first and second ferromagnets FM1, FM2 separated by a thin insulative layer IL, such as MgO. An upper contact UC can be provided on the first ferromagnet FM1 and a lower contact LC can be provided on the second ferromagnet FM2. A substrate S can support the MTJ structure. The insulative layer should be thin, in the order of a few nanometers, so as to allow electrons to 'tunnel' from one of the ferromagnets to the other. It will be appreciated that this is a quantum mechanical phenomenon.

The direction of the two magnetizations of the ferromagnetic films FM1, FM2 can be switched individually by an external magnetic field. If the magnetizations are in a parallel orientation, it is more likely that electrons will tunnel through the insulating film IL than if they are in the oppositional (antiparallel) orientation. Consequently, such a junction can be switched between two states of electrical resistance, one with low resistance and one with high resistance.

It is understood that the directions of FM1 and FM2 do not necessarily have to be switched: if the external field angle is neither parallel or anti-parallel then the resulting magnetization changes as the composite angle between the external field and the reference layer. The resistance variation is proportional to the cosine of such composite angle which makes TMR elements useful for angle sensing applications.

Electrons with certain spin orientation ("spin-up" or "spin-down") can tunnel from one ferromagnetic layer to another ferromagnetic layer through the non-conductive thin insulating layer if there are available free states with the same spin orientation. In case of the parallel state, the majority spin ("spin-up") electrons and minority spin ("spin-down") electrons can tunnel to the second ferromagnetic layer and fill majority ("up") and minority ("down") states, respectively. This will result in large conductance and corresponds to the low resistive state. In case of the anti-parallel state, the majority spin ("spin-down") electrons and minority spin ("spin-up") electrons from first ferromagnetic layer fill the minority ("down") and majority ("up") states in the second ferromagnetic layer, respectively. This will result in the low conductance and corresponds to the high resistive state. Tunneling magnetoresistance is described in J. Mathon, Theory of Tunneling Magnetoresistance, 76 PHASE TRANSITIONS 491-500 (2003), which is incorporated herein by reference.

FIG. 5 shows an example TMR stack 500 having a reference layer 502 that includes an antiferromagnetic pinning layer 502a and a ferromagnetic pinned layer 502b, an insulative barrier layer 504, which may be referred to as a spacer, a vortex layer 506, and a biasing layer 508. As can be seen, and as described more fully below, a vortex 510 in the vortex layer 506 is offset due to magnetic exchange bias from the biasing layer 508. It is understood that the respective arrows indicate field orientation.

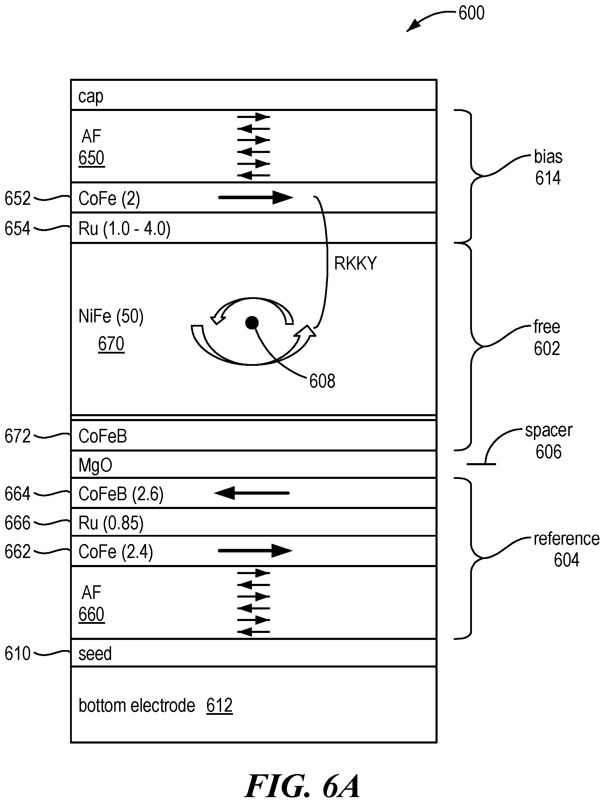

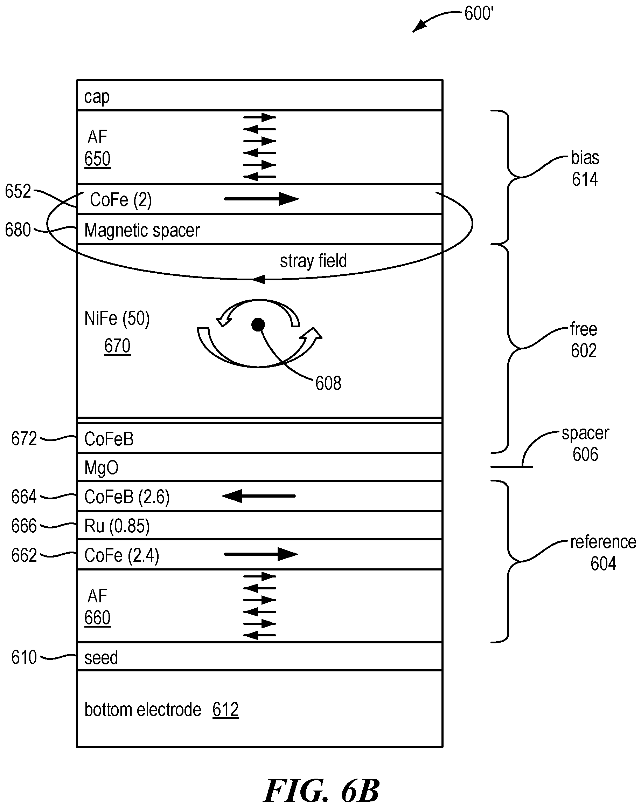

FIGs. 6A and 6B show example configurations for TMR stacks with a magnetic vortex offset in the free layer to enhance linearization of the transfer curve. The vortex is offset due to magnetic bias, as described more fully below. The example stacks provide a magnetoresistance element having a plurality of material layers stacked on top of one another and configured to have vortex characteristics in accordance with example embodiments of the disclosure. Each of the material layers in the stack has electrical and magnetic properties which, when placed together, cause the magnetoresistance element to react to external magnetic fields. In embodiments, the magnetoresistance element comprises a spin valve. Spin valves minimally have two layers: a fixed (also referred to as a reference) layer having a fixed magnetic alignment and a free layer having a magnetic alignment that changes in response to an external magnetic field. When the magnetic alignment of the free layer is lined up with the magnetic alignment of the reference layer, the electrical resistance of the spin valve has a minimal value. Conversely, when the magnetic alignment of the free layer is aligned in an opposite direction to the reference layer, the electrical resistance of the spin valve is at a maximum value. At points in between, the resistance is at an intermediate value. Generally, as the magnetic alignment of the free layer changes from one extreme (e.g., oppositely aligned with the reference layer) to the other extreme (e.g. aligned with the reference layer), the electrical resistance of the spin valve changes linearly from its maximum value to its small value. The MR element can be driven with a current that flows between the bottom electrode and the cap.

FIG. 6A shows an example TMR element 600 having a free layer 602 and a reference layer 604 separated by a spacer layer 606 which combine to enable a magnetic vortex 608 with cylindrical arrows indicative of orientation. The reference layer 604 may be disposed on a seed layer 610 e.g., a copper nitride (CuN), coupled to an electrode 612. A bias layer 614 is positioned adjacent to the free layer 602 that causes an offset in the location of the vortex 608 in the free layer. The bias layer 614 is coupled through magnetic interaction to the free layer 602. The bias layer 614 is aligned in a certain direction by means of field cooling. The magnetic coupling can be regarded as an effective magnetic field acting on the interface of the free layer 602 to the bias layer 614. The free layer 602 tries to align with this effective field while the vortex is still persistent. The vortex core will therefore be offset from the center of the pillar in an orthogonal direction to the bias layer magnetization to minimize the total energy of the system. In the illustrated embodiment, the bias layer 614 comprises an antiferromagnetic layer 650, along with a CoFe layer 652 and an Ru layer 654. It is understood that arrows in the respective layers indicate field orientation.

In the illustrated embodiment, the reference layer 604 can include an antiferromagnetic (AF) layer 660 located on the seed layer 610. The reference layer 604 can further include first and second pinning layers 662, 664 separated by a spacer 666. In one embodiment, the first layer 662 comprises CoFe, the second pinning layer 664 comprises CoFeB, and the spacer 666 comprises Ru, with the first and second pinning layers having in plane field sensitivity and opposite orientation, as indicated by the respective arrows.

In the illustrated embodiment, the spacer layer 606 comprises MgO and facilitates a spin dependent electron tunneling process.

The free layer 602 includes a vortex layer 670, which can comprise NiFe, for example. Below the vortex layer 670, the free layer 602 comprises a coupling layer 672. In the illustrated embodiment, the coupling layer 672 comprises CoFeB adjacent to the vortex layer 670.

In the illustrated embodiment, coupling of the vortex layer 670 to the bias layer 614 can be achieved with RKKY interaction, where the thickness of the spacer 654 modulates the direction and the amplitude of the coupling. It is understood that RKKY (Ruderman-Kittel-Kasuya-Yosida) interaction refers to a coupling mechanism of nuclear magnetic moments of localized d- or f- shell electron spins in a metal by means of an interaction through conduction electrons.

FIG. 6B shows an example TMR element 600' having some commonality with the element 600 of FIG. 6A with a magnetic spacer 680 (FIG. 6B) layer instead of an Ru layer 654 (FIG. 6B). The magnetic spacer 680 provides stray field coupling. The magnetic spacer layer 680 does not facilitate RKKY interaction in this embodiment. The coupling of free layer 602 and bias layer 614 happens through magnetic stray field instead of RKKY. Example AF materials include Iridium Manganese (IrMn), Platinum Manganese (PtMn), Iron Manganese (FeMn), Nickel Manganese (NiMn), Nickel Oxide (NiO).

It is understood that the magnetic spacer can comprise any suitable material to meet the needs of a particular application. Copper is one example material. Other example materials include titanium, silver, and tantalum.

It is understood that in example embodiments, such as TMR elements 600 and 600', a stackup comprises a spin valve device so that the electrical resistance of magnetoresistance element changes as the magnetic alignment between different material layers changes. In the illustrated embodiment, the TMR element 600, 600' has a stack of layers indicative of one pillar of a multi-pillar TMR element.

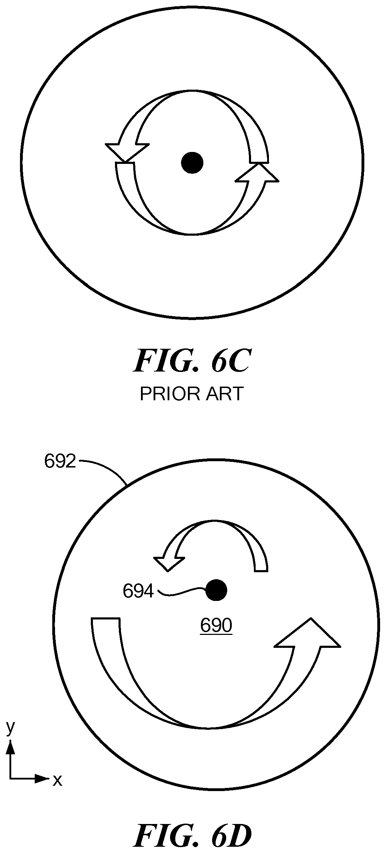

FIG. 6C shows a conventional vortex generated in known TMR stack configurations.

FIG. 6D shows an example vortex 690 that is offset from center as generated by TMR stack configurations, such as those shown in FIGs. 6A and/or 6B. As can be seen, the magnetic vortex 690 structure has its lowest energy state in the center of the pillar 692 when no external field or other bias is applied. The magnet bias exerted by the biasing layer, such as bias layer 614 in FIGs. 6A and 6B, is set by field cooling to align the magnetization parallel in direction +x.

The magnetization in the free layer 602 reacts to the bias by enlargement of the area that is aligned parallel to +x. This results in the vortex core 694 being offset in direction +y in this example.

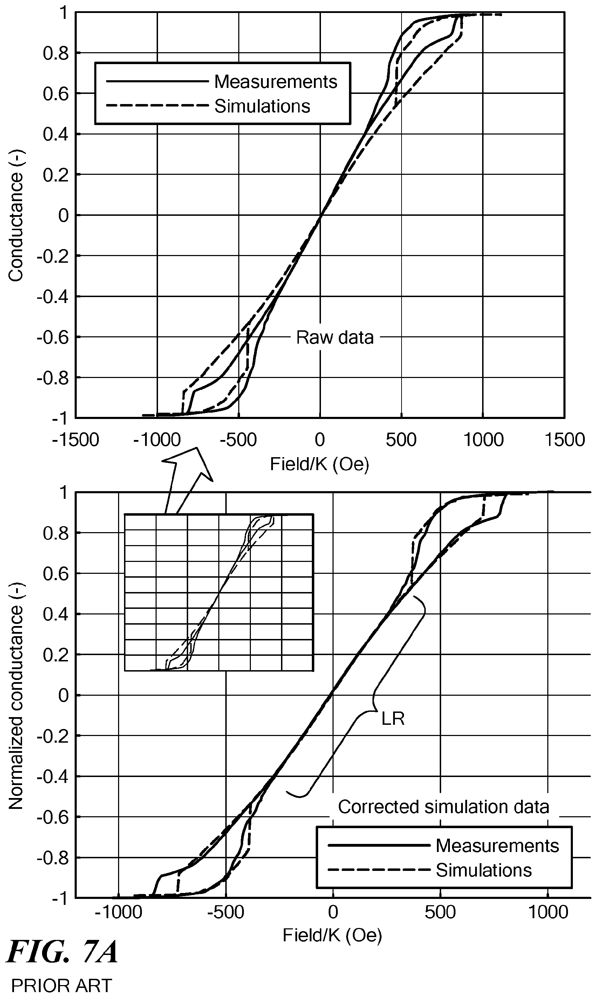

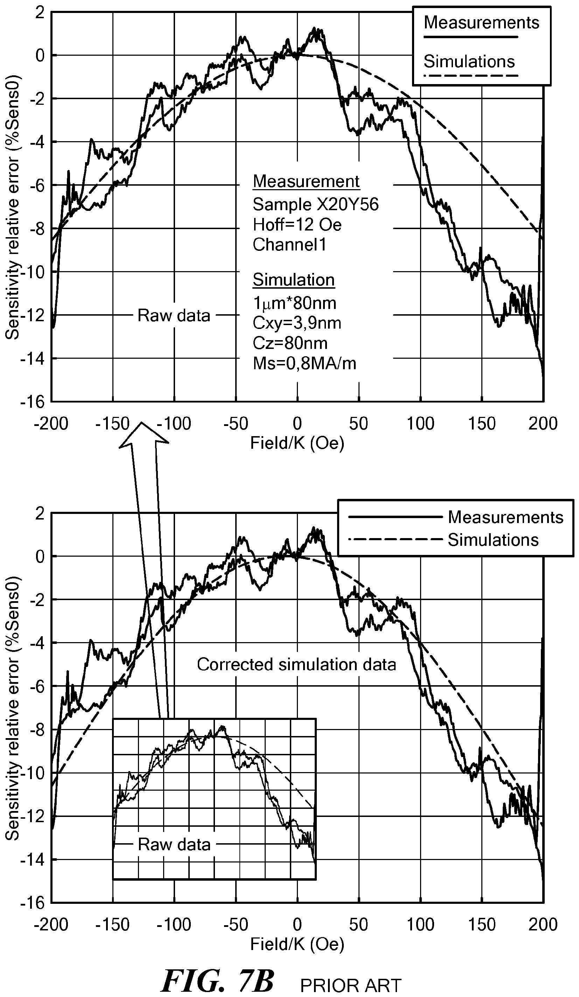

FIGs. 7A and 7B show linearity of example devices in accordance with illustrative embodiments of the disclosure. FIG. 7A shows normalized conductance for an example stackup for a TMR element versus applied field and FIG. 7B shows sensitivity relative error versus applied field for raw (example device) and corrected simulation data. As can be seen in FIG. 7A, in a linear region LR, the change in conductance over change in field is not perfectly linear and has a slight "S" shape as it goes above and below a straight line. This deviation from a straight line can be considered to be linearity error. The steepness of the line corresponds to sensitivity of the TMR element. FIG. 7B shows percentage sensitivity error from -200 Oe to +200 Oe. Due to the "S" shape of the conductance, as can be seen, sensitivity error has a convex shape with about -10% error at -200 Oe, -12% at +200 Oe, and 0% at 0 Oe.

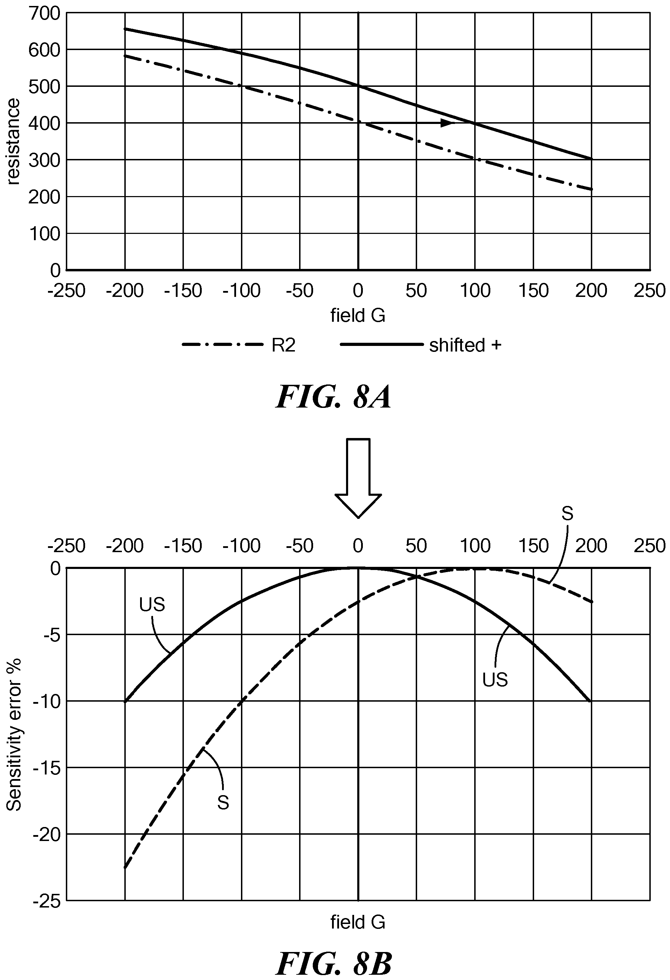

FIG. 8A shows resistance over field with a shift of the transfer curve by +100G due to biasing (e.g., bias layer 614 FIG. 6A,B) of the vortex and FIG. 8B shows sensitivity error over applied field for shifted S and unshifted US transfer curves and. The biasing effect shifts the maximum of the device sensitivity by 100G, for example.

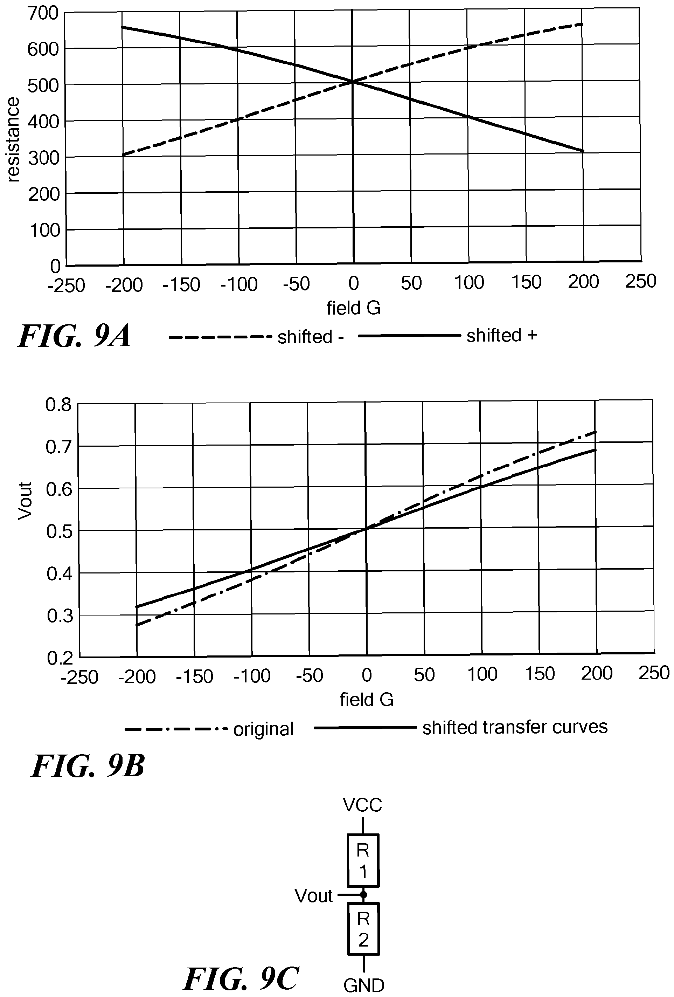

FIG. 9A shows resistance versus field for shifted transfer curves with opposite reaction to a magnetic field through opposite pinning directions and FIG. 9B shows output signal Vout versus field for unshifted and shifted transfer curves for the example half bridge of FIG. 9C. As can be seen, the shifted transfer curves provide decreased sensitivity of the half bridge output signal Vout compared to unshifted transfer curves. That is, the bias layer generates an offset of the vortex that shifts the transfer curves to decrease sensor sensitivity.

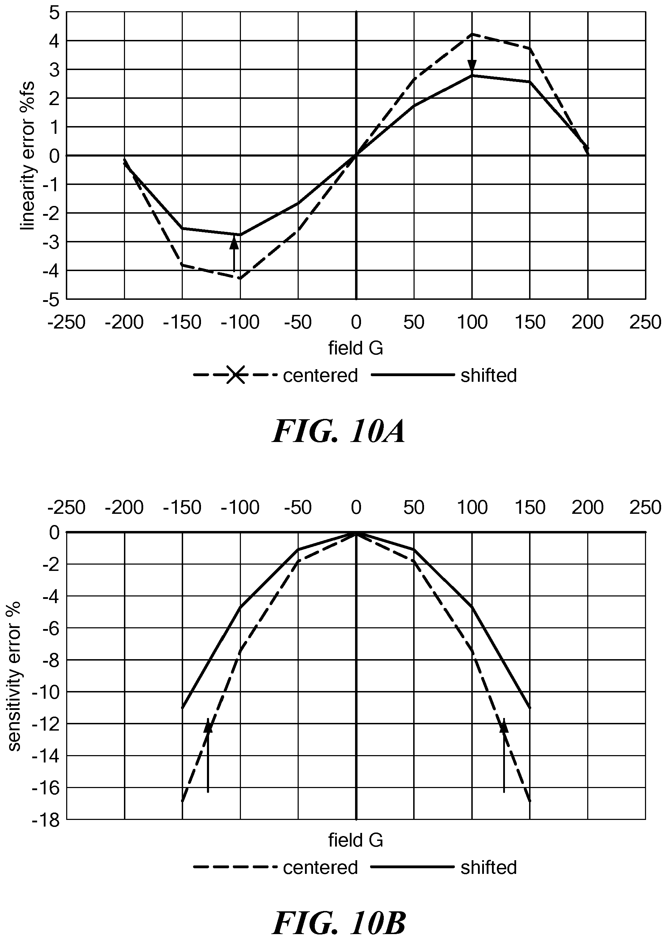

FIG. 10A shows linearity error and FIG. 10B shows sensitivity error of the half bridge output voltage from FIG. 9B versus field for centered (unshifted) and shifted transfer curves. As can be seen, biasing the vortex provides a reduction of linearity deviation and sensitivity error as compared with conventional sensors without biasing of the vortex.

As used herein, the term "anisotropy" or "anisotropic" refer to a particular axis or direction to which the magnetization of a ferromagnetic or ferrimagnetic layer tends to orientate when it does not experience an additional external field. An axial anisotropy can be created by a crystalline effect or by a shape anisotropy, both of which allow two equivalent directions of magnetic fields. A directional anisotropy can also be created in an adjacent layer, for example, by an antiferromagnetic layer, which allows only a single magnetic field direction along a specific axis in the adjacent layer.

In view of the above, it will be understood that introduction of an anisotropy in a magnetic layer results in forcing the magnetization of the magnetic layer to be aligned along that anisotropy in the absence of an external field. In the case of a GMR or TMR element, a directional anisotropy provides an ability to obtain a coherent rotation of the magnetic field in a magnetic layer in response, for example, to an external magnetic field.

In general, magnetic materials can have a variety of magnetic characteristics and can be classified by a variety of terms, including, but not limited to, ferromagnetic, antiferromagnetic, and nonmagnetic. Description of the variety of types of magnetic materials is not made herein in detail. However, let it suffice here to say, that a ferromagnetic material is one in which magnetic moments of atoms within the ferromagnetic material tend to, on average, align to be both parallel and in the same direction, resulting in a nonzero net magnetic magnetization of the ferromagnetic material.

An antiferromagnetic material is one in which magnetic moments within the antiferromagnetic material tend to, on average, align to be parallel, but in opposite directions in sub-layers within the antiferromagnetic material, resulting in a zero net magnetization.

As used herein, the term "magnetic field sensing element" is used to describe a variety of electronic elements that can sense a magnetic field. The magnetic field sensing element can be, but is not limited to, a Hall effect element, a magnetoresistance element, or a magnetotransistor. As is known, there are different types of Hall effect elements, for example, a planar Hall element, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, for example, a spin valve, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb).

As is known, some of the above-described magnetic field sensing elements tend to have an axis of maximum sensitivity parallel to a substrate that supports the magnetic field sensing element, and others of the above-described magnetic field sensing elements tend to have an axis of maximum sensitivity perpendicular to a substrate that supports the magnetic field sensing element. In particular, planar Hall elements tend to have axes of sensitivity perpendicular to a substrate, while metal based or metallic magnetoresistance elements (e.g., GMR, TMR, AMR) and vertical Hall elements tend to have axes of sensitivity parallel to a substrate.

As used herein, the term "magnetic field sensor" is used to describe a circuit that uses a magnetic field sensing element, generally in combination with other circuits. Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field.

As used herein, the term "magnetic field sensor" is used to describe a circuit that uses a magnetic field sensing element, generally in combination with other circuits. Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field. As used herein, the terms "target" and "magnetic target" are used to describe an object to be sensed or detected by a magnetic field sensor or magnetic field sensing element.

Various embodiments of the concepts, systems, devices, structures and techniques sought to be protected are described herein with reference to the related drawings. Alternative embodiments can be devised without departing from the scope of the concepts, systems, devices, structures and techniques described herein. It is noted that various connections and positional relationships (e.g., over, below, adjacent, etc.) are set forth between elements in the following description and in the drawings. These connections and/or positional relationships, unless specified otherwise, can be direct or indirect, and the described concepts, systems, devices, structures and techniques are not intended to be limiting in this respect. Accordingly, a coupling of entities can refer to either a direct or an indirect coupling, and a positional relationship between entities can be a direct or indirect positional relationship.

As an example of an indirect positional relationship, references in the present description to forming layer "A" over layer "B" include situations in which one or more intermediate layers (e.g., layer "C") is between layer "A" and layer "B" as long as the relevant characteristics and functionalities of layer "A" and layer "B" are not substantially changed by the intermediate layer(s).The following definitions and abbreviations are to be used for the interpretation of the claims and the specification. As used herein, the terms "comprises," "comprising, "includes," "including," "has," "having," "contains" or "containing," or any other variation thereof, are intended to cover a non-exclusive inclusion. For example, a composition, a mixture, process, method, article, or apparatus that comprises a list of elements is not necessarily limited to only those elements but can include other elements not expressly listed or inherent to such composition, mixture, process, method, article, or apparatus.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Unless otherwise specified, the term "substantially" refers to values that are within ±10%. For example, a first direction that is "substantially" perpendicular to a second direction may refer to a first direction that is within ±10% of making a 90° angle with the second direction.

Having described exemplary embodiments of the disclosure, it will now become apparent to one of ordinary skill in the art that other embodiments incorporating their concepts may also be used. The embodiments contained herein should not be limited to disclosed embodiments but rather should be limited only by the spirit and scope of the appended claims. All publications and references cited herein are expressly incorporated herein by reference in their entirety.

Elements of different embodiments described herein may be combined to form other embodiments not specifically set forth above. Various elements, which are described in the context of a single embodiment, may also be provided separately or in any suitable subcombination. Other embodiments not specifically described herein are also within the scope of the following claims.

## Claims

1. A device, comprising:
a TMR element comprising:
a free layer having a vortex layer to provide a magnetic vortex;
a spacer layer;
a reference layer; and
a bias layer to offset the vortex by magnetic bias.

2. The device according to claim 1, wherein the bias layer comprises an antiferromagnet layer.

3. The device according to claim 2, wherein the bias layer comprises a CoFe layer.

4. A device, comprising:
two or more biased vortex TMR elements electrically connected to form a half bridge and pinned in opposite directions to create an output signal when a magnetic field is applied; and
a free layer biased in opposite directions to have a same pinning direction for enhancing linearity of the output signal of the half bridge.

5. A device, comprising:
four or more biased vortex TMR elements electrically connected to form a full bridge and pinned in opposite directions to create an output signal when a magnetic field is applied; and
a free layer biased in opposite directions for enhancing linearity of the output signal of the full bridge.

6. A method, comprising:
forming a TMR element to comprise:
a free layer having a vortex layer to provide a magnetic vortex;
a spacer layer;
a reference layer; and
a bias layer to offset the vortex by magnetic bias.

7. The method according to claim 6, wherein the bias layer comprises an antiferromagnet layer.

8. The method according to claim 7, wherein the bias layer comprises a CoFe layer.

9. The method according to claim 8, or the device according to claim 3, wherein the bias layer comprises a magnetic spacer.

10. The method according to claim 8, or the device according to claim 3, wherein the bias layer comprises a Ru layer.

11. The method according to claim 6, or the device according to claim 1, wherein the vortex layer comprises NiFe.

12. The method according to claim 6, or the device according to claim 1, wherein the vortex layer is configured for RKKY coupling with the bias layer.

13. The method according to claim 6, or the device according to claim 1, wherein the vortex layer is configured for stray field coupling with the bias layer.

14. The method according to claim 6, or the device according to claim 1, wherein the vortex layer is configured for exchange bias.

15. The method according to claim 6, or the device according to claim 1, wherein the reference layer comprises an antiferromagnetic layer.

16. The method according to claim 6, or the device according to claim 1, wherein the bias layer is configured to shift a transfer curve of the TMR element.

17. The method according to claim 6, or the device according to claim 1, wherein the bias layer is configured to shift a transfer curve of the TMR element by a given amount of applied field.

18. The method according to claim 6, or the device according to claim 1, wherein the bias layer is configured to shift a sensitivity error versus applied field transfer curve of the TMR element.
